Europäisches Patentamt

European Patent Office

Office européen des brevets

(11) Numéro de publication: **0 267 422 B1**

## FASCICULE DE BREVET EUROPEEN

(45) Date de publication de fascicule du brevet:
29.05.91

(51) Int. Cl.⁵: **H03L 7/12**

(21) Numéro de dépôt: 87114515.7

(22) Date de dépôt: 05.10.87

(54) **Procédé et dispositif d'aide à l'acquisition d'une boucle à verrouillage de phase.**

(30) Priorité: 08.10.86 FR 8614010

(43) Date de publication de la demande:
18.05.88 Bulletin 88/20

(45) Mention de la délivrance du brevet:
29.05.91 Bulletin 91/22

(84) Etats contractants désignés:
DE FR GB IT NL SE

(56) Documents cités:
FR-A- 2 322 490
US-A- 4 246 546

(73) Titulaire: ALCATEL CIT
12 Rue de la Baume
F-75008 Paris(FR)

(72) Inventeur: Balzano, Jean-Michel
Dour Dian Rue de Seunteun Léo
F-22700 Perros Guirec(FR)

(74) Mandataire: Weinmiller, Jürgen et al
Lennéstrasse 9 Postfach 24
W-8133 Feldafing(DE)

Rank Xerox (UK) Business Services

## Description

La présente invention concerne le domaine des boucles à verrouillage de phase et, plus particulièrement, un procédé et un dispositif d'aide à l'acquisition permettant un accrochage de la boucle plus rapide et dans une plage de fréquences plus large.

Dans le cadre de la transmission de données numériques à très haut débit, on est amené à régénérer périodiquement, en amplitude et en phase, le signal. Pour cela, l'horloge est nécessaire et il faut l'extraire des données transmises, ce qui pose un problème de filtrage délicat lorsque les codes utilisés sont du type NRZ ou RZ car il y a peu de transitions.

Hormis des dispositifs de filtrage passif, tels que les filtres à ondes de surface par exemple, les boucles à verrouillage de phase sont utilisées. Dans cette application qui consiste à isoler d'un spectre une composante fréquentielle particulière, les boucles sont dites étroites (pulsation propre petite devant la pulsation centrale), ce qui conduit à une bande d'accrochage faible et un temps d'accrochage long.

Pour pallier ces inconvénients, plusieurs dispositifs sont connus:

Utilisation d'un oscillateur à quartz commandé en tension qui permet une précision de la fréquence centrale suffisante pour être dans tous les cas à l'intérieur de la bande d'accrochage. Le temps d'accrochage lui est court puisque l'écart de fréquence initial est faible. Mais l'emploi d'un quartz aux forts débits (supérieurs à 34Mbit/s) implique des coûts élevés et en outre n'exclut pas tout réglage.

Adjonction à la boucle à verrouillage de phase initiale, d'une boucle à verrouillage de fréquence. Un tel système est décrit dans le brevet français 2 322 490 du 19 août 1977 : Circuit de correction d'erreurs de synchronisation. Il génère une tension d'erreur, proportionnelle à l'écart de fréquence entre entrée et sortie, qui est utilisée pour réaliser l'accrochage fréquentiel. Ce dispositif conduit à une réalisation complexe et à des ajustements de phase délicats.

Un autre procédé consiste à utiliser un générateur externe de dents de scie dont la sortie vient s'ajouter à la tension de commande de l'oscillateur commandé en tension. On réalise alors un balayage de la fréquence de celui-ci ; le passage par l'accrochage est détecté en utilisant un deuxième comparateur de phase, travaillant en quadrature avec le premier, un filtre passe-bas et un comparateur de niveau. L'accrochage se traduit en sortie du deuxième comparateur de phase par l'apparition d'une composante continue détectée par le filtre passe bas et le comparateur de niveau, on supprime alors la dent de scie de balayage. Ce dispositif nécessite un nombre important de composants externes et de plus ne présente pas une grande immunité vis-à-vis de la gigue du signal d'entrée.

L'invention a pour but de pallier les inconvénients des solutions connues, et d'obtenir un dispositif de réalisation simple et de mise en oeuvre aisée.

L'invention selon la revendication 1 a pour objet un procédé d'aide à l'acquisition d'une boucle à verrouillage de phase recevant un signal d'entrée de fréquence f1 et comprenant un comparateur de phase, un filtre passe-bas, un filtre de boucle et un oscillateur commandé en tension et délivrant un signal de fréquence f2 avant accrochage, ledit filtre passe-bas délivrant au filtre de boucle un signal en dents de scie de fréquence f1-f2, caractérisé par le fait que l'on met en forme, en dehors de la boucle à verrouillage de phase, ledit signal en dents de scie par un comparateur à hystérésis, que l'on filtre le signal mis en forme pour élimination des fréquences inférieures à une fréquence de capture de la boucle à verrouillage de phase, que l'on effectue une multiplication du signal ainsi filtré par un signal carré basse fréquence pour obtenir un signal multiplié, que l'on intègre ledit signal multiplié pour obtenir un signal de balayage tant que l'acquisition n'est pas obtenue, et que l'on commande ledit oscillateur par ledit signal de balayage pour en faire varier la fréquence, ledit signal de balayage ayant une fréquence égale à celle dudit signal basse fréquence et passant linéairement d'une valeur crête positive à une valeur crête négative et inversement.

L'invention selon la revendication 3 a également pour objet un dispositif mettant en oeuvre le procédé de l'invention, et comportant un comparateur à hystérésis un filtre passe-haut, un multiplieur, et un générateur de signaux carrés basse fréquence, le comparateur à hystérésis étant relié en sortie du filtre passe-bas de la boucle à verrouillage de phase, le filtre passe-haut étant relié en sortie du comparateur à hystérésis, le multiplieur ayant une entrée reliée en sortie du filtre passe-haut, une entrée reliée en sortie du générateur et une sortie reliée au filtre de boucle de ladite boucle à verrouillage de phase.

Une boucle de verrouillage de phase recevant un signal d'entrée est constituée classiquement par un comparateur de phase, un filtre passe-bas, un filtre de boucle et un oscillateur commandé en tension, le filtre passe-bas délivrant au filtre de boucle un signal en dents le scie. Conformément à l'invention ledit signal en dents de scie est, en dehors de la boucle à verrouillage de phase, multiplié par un signal carré basse fréquence, et le signal obtenu par multiplication est intégré pour obtenir un signal de balayage qui est appliqué à l'oscillateur pour en faire varier la fréquence entre deux valeurs extrêmes.

Lorsque l'accrochage de la boucle à verrouillage de phase est obtenu, le signal de balayage disparaît ; cependant pour éviter après accrochage que lors d'une gigue du signal d'entrée, ou encore lorsque le signal d'entrée comporte une longue suite de "0" ou de "1", un signal de balayage apparaisse, le signal en dents de scie est mis en forme par un comparateur à hystérésis, avant multiplication. Enfin, toujours selon le procédé, le signal résultant de la comparaison est filtré pour éliminer les fréquences inférieures à la fréquence de capture de la boucle à verrouillage de phase.

Le procédé de l'invention est mis en oeuvre dans un dispositif d'aide à l'acquisition de la boucle à verrouillage de phase ; ce dispositif présente les avantages suivants ;

- L'accrochage atteint, le dispositif d'aide à l'acquisition est totalement inhibé et ne vient donc pas perturber le fonctionnement de la boucle à verrouillage de phase seule.
- Il est totalement intégrable et nécessite l'ajout d'un nombre d'éléments peu élevé à la boucle à verrouillage de phase initiale. On minimise ainsi la consommation supplémentaire.
- Les composants externes sont classiques donc de faible coût (pas de quartz ou de filtre à ondes de surface).
- Aucun réglage n'est à effectuer lors de la mise en service du dispositif.
- Il est susceptible de pouvoir extraire le signal d'horloge d'un signal binaire comportant de longues suites de "0" ou de "1" et perturbé par une gigue importante.

L'invention sera bien comprise lors de la description suivante d'un exemple de réalisation illustré par les figures annexées dans lesquelles:

- la figure 1 est un schéma d'un dispositif de l'invention,
- la figure 2 représente l'allure de différents signaux en divers points du dispositif de la figure 1,
- la figure 3 est un schéma de certains organes de la figure 1.

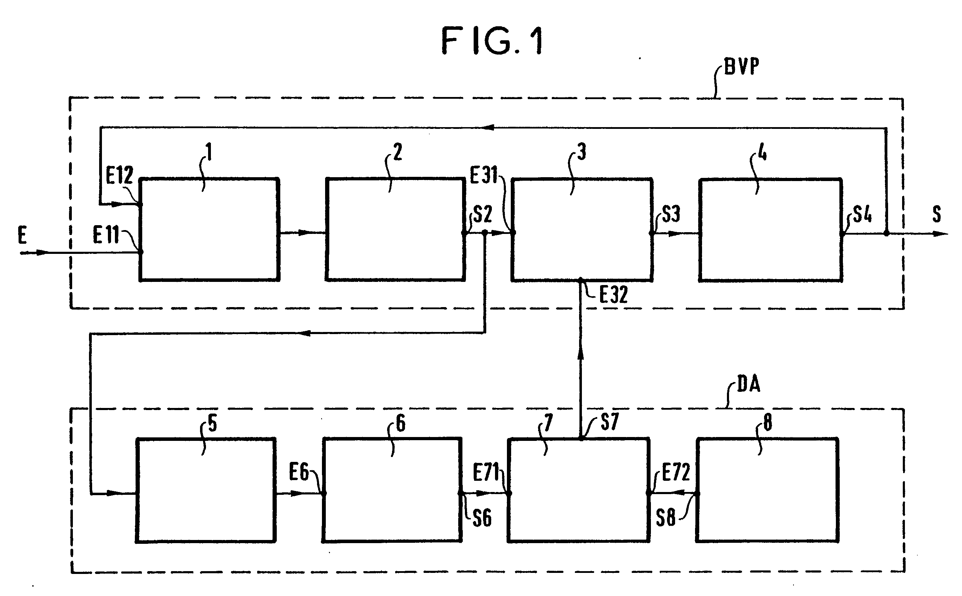

La figure 1 représente une boucle à verrouillage de phase BVP, classique et un dispositif d'aide à l'acquisition DA de l'invention.

La boucle à verrouillage de phase BVP comporte un comparateur de phase 1 ayant une caractéristique triangulaire, en dents de scie, (du type OU exclusif) ayant une première entrée E 11 qui reçoit un signal d'entrée E, un filtre passe-bas 2 ayant une entrée reliée en sortie du comparateur de phase, un filtre de boucle 3 ayant une première entrée E 31 reliée en sortie S2 du filtre passe-bas 2, et un oscillateur 4, commandé en tension, ayant une entrée reliée en sortie S3 du filtre de boucle 3 et une sortie S4 reliée à une deuxième entrée E 12 du comparateur de phase 1 ; la sortie S4 délivre un signal de sortie S.

Le dispositif d'aide à l'acquisition DA comporte un comparateur à hystérésis 5 relié en entrée à la sortie S2 du filtre passe-bas 2, un filtre passe-haut 6 ayant une entrée E6 reliée en sortie du comparateur à hystérésis 5, un multiplieur 7 à deux quadrants et un générateur 8 de signaux carrés basse fréquence de période T, le multipleur 7 ayant une première entrée E 71 reliée en sortie S6 du filtre passe-haut 6, une deuxième entrée E 72 reliée en sortie S8 du générateur 8, et une sortie S7 reliée à une deuxième entrée E 32 du filtre de boucle 3.

On va donner à présent le fonctionnement de l'ensemble boucle à verrouillage de phase BVP et dispositif d'aide à l'acquisition DA en supposant tout d'abord que la boucle à verrouillage de phase est ouverte entre le filtre de boucle 3 et l'oscillateur 4. Le signal d'entrée E a une fréquence f1 et le signal de sortie S a une fréquence f2, différente de f1.

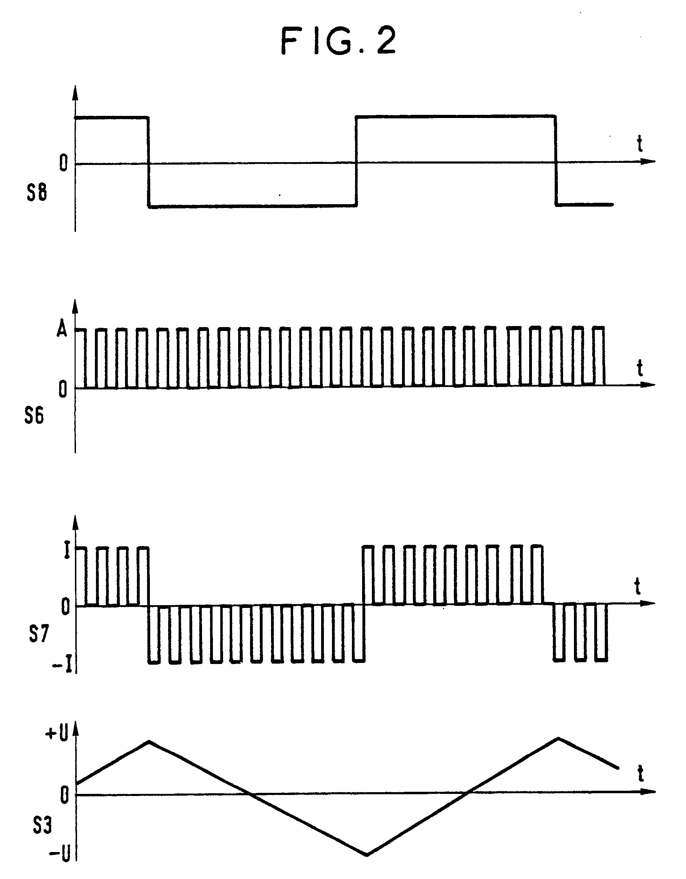

Le comparateur de phase 1 délivre un signal comportant les composantes somme f1 + f2 des fréquences, et différence f1 - f2 des fréquences ; par exemple si la fréquence f1 est supérieure à la fréquence f2, la somme f1 + f2 est éliminée par le filtre passe-bas 2. En conséquence le signal en sortie S2 du filtre passe-bas est l'image de la caractéristique du signal en dents de scie délivré par le comparateur de phase 1, c'est-à-dire un triangle de fréquence f1 - f2 et d'amplitude A. L'hystérésis du comparateur à hystérésis 5 est ajusté à une valeur A-ε légèrement inférieure à A de manière à déclencher sur le signal délivré par le filtre passe-bas. En sortie du comparateur à hystérésis donc à l'entrée E6 du filtre passe-haut on obtient un signal carré de niveau bas 0 et de niveau haut A, toujours de fréquence f1 - f2, représenté figure 2, qui se transmet en sortie S6 du filtre passe-haut 6 qui est supposé être transparent à la fréquence f1 - f2. Le multiplieur 7 reçoit sur sa première entrée E71, unipolaire, le signal délivré par le filtre passe-haut 6 sur sa sortie S6, figure 2, et sur sa deuxième entrée E 72, bipolaire, un signal carré délivré par générateur 8 en sortie S8, figure 2, ledit signal carré ayant une fréquence 1/T choisie petite devant la fréquence de capture de la boucle à verrouillage de phase ; cette fréquence de capture est l'écart de fréquence maximum à partir duquel l'accrochage s'effectue sans saut de phase, donc sans déclenchement du comparateur à hystérésis 5. D'autre part le signal carré délivré par le générateur 8 est constitué d'alternances positives et négatives, le signe de la tension de ce signal changeant à chaque basculement du signal carré. Par conséquent le signal délivré par la sortie S7 du multiplieur et représenté figure 2 est : carré, de niveau bas 0, de niveau haut I, de fréquence f1 - f2 pendant l'alternance positive du signal délivré par le générateur 8, et carré de niveau bas -I, de niveau haut 0 et de fréquence f1 - f2 pendant l'alternance négative du signal délivré par le générateur 8. Le signal délivré par le multiplieur 7 est ensuite intégré par le filtre de boucle 3, comme cela sera expliqué plus loin. En sortie S3 du filtre de boucle le signal de balayage délivré est constitué, comme représenté figure 2, par une rampe de pente positive d'amplitude +U correspondant à l'intégration de la partie positive du signal sur la sortie S7 du multiplieur, puis par une rampe de pente négative d'amplitude -U correspondant à l'intégration de la partie négative du signal sur la sortie S7 ; le signal délivré par le filtre de boucle 3 est donc une tension triangulaire de période T, passant par la valeur 0 au milieu de chaque rampe positive et négative.

L'oscillateur 4, qui est commandé en tension par le signal de balayage délivré par le filtre de boucle, se trouve ainsi balayé linéairement en fréquence lorsque la boucle est fermée.

L'écart de fréquence entre les signaux délivrés par les sorties S6 et S8, figure 2, est en fait beaucoup plus important que celui représenté dans cette figure, mais le fonctionnement reste bien évidemment le même. De même le signal de balayage délivré par la sortie S3, figure 2, devrait avoir une allure de marches d'escalier, chaque marche correspondant à l'intégration d'une impulsion du signal sur la sortie S7, mais plus l'écart de fréquence est grand plus les marches sont petites. On peut donc considérer que le signal de balayage varie linéairement entre +U et -U. On observera que le filtre de boucle 3 reçoit également le signal en dents de scie délivré par le filtre passe-bas 2, et que ce signal se superpose, en sortie S3 du filtre de boucle, au signal de balayage ; le niveau de ce signal en dents de scie, de fréquence f1 - f2, étant beaucoup plus faible que celui du signal de balayage, il n'en a pas été tenu compte dans la figure 2. Il faut cependant noter, qu'après l'accrochage le signal de balayage est supprimé, comme cela est expliqué ci-après, et que seul le signal en dents de scie subsiste, ce signal étant celui de la boucle à verrouillage de phase en fonctionnement normal.

On va décrire à présent le fonctionnement en boucle fermée. A l'instant initial de la fermeture la boucle n'est pas accrochée ; par conséquent les fréquences des signaux d'entrée E et de sortie S sont différentes, ce qui correspond au cas décrit précédemment. Le comparateur de phase 1 délivre un signal en dents de scie à la fréquence de battement f1 - f2 entre la fréquence f1 des signaux d'entrée et la fréquence f2 du signal de sortie. Comme indiqué précédemment le dispositif d'aide à l'acquisition DA va engendrer, à partir du signal en dents de scie, délivré par le filtre passe-bas 2 qui est l'image du signal en dents de scie délivré par le comparateur de phase 1, un signal qui est appliqué au filtre de boucle 3, lequel délivre le signal de balayage commandant l'oscillateur 4. En sortie S3 du filtre de boucle, au signal de balayage se superpose le signal délivré par le filtre passe-bas 2, sur sa sortie S2, qui est le signal d'accrochage naturel de la boucle à verrouillage de phase BVP ; mais tant que l'écart de fréquence f1 - f2 est supérieur à la bande de capture, le signal de balayage est prépondérant et intervient seul. Inversement, au moment du passage à l'intérieur de la bande de capture les sauts de phase disparaissent et donc le signal de balayage disparait également.

Il ne reste donc en sortie S3 du filtre de boucle que le signal d'accrochage naturel qui va conduire au synchronisme très rapidement puisque le fonctionnement se situe dans la bande de capture. Quel que soit l'écart de fréquence initial, le temps d'accrochage sera donc inférieur à 3T/2, T étant la période du générateur 8 de signaux carrés basse fréquence. Ce temps maximum correspond à un saut entre les deux fréquences extrêmes de fonctionnement se produisant juste après un basculement du générateur 8.

En effet au prochain basculement, lorsque la tension du signal carré change de signe, le signal de balayage n'aura pas atteint la fréquence extrême puisque le balayage s'effectue à pente constante et qu'il aura duré moins de T/2 ; il faudra alors attendre une nouvelle période du signal de balayage pour obtenir l'accrochage.

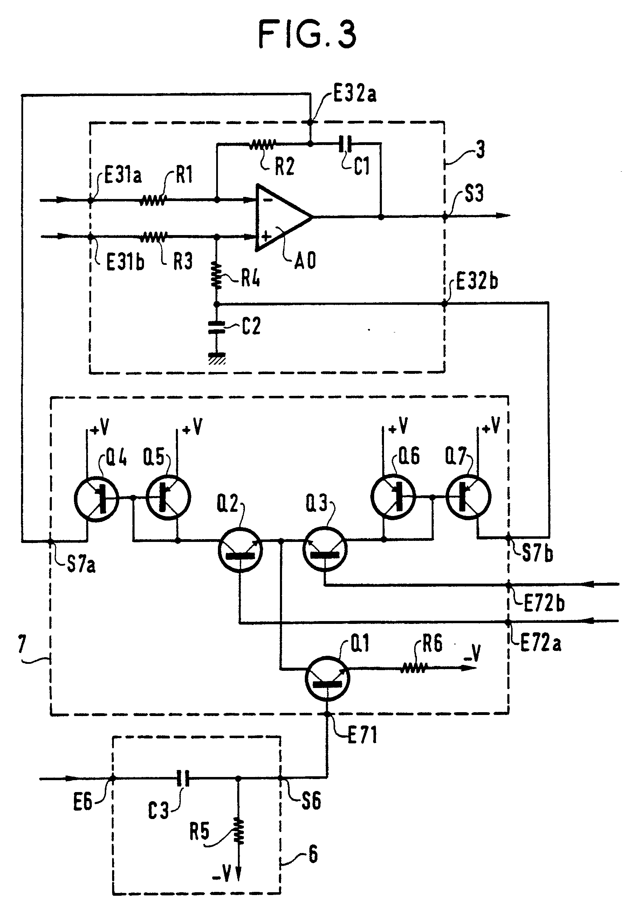

La figure 3 représente le filtre de boucle 3, le filtre passe-haut 6 et le multiplieur 7 à deux quadrants.

Le filtre passe-haut 6 comprend un condensateur C3 entre son entrée E6 et sa sortie S6 et une résistance R5 entre la sortie S6 et une tension négative -V.

Le multiplieur 7 comprend sept transistors Q1 à Q7 et une résistance R6. Les transistors Q1, Q2, Q3 sont du type NPN, les transistors Q4 à Q7 étant du type PNP. Les transistors Q2 et Q3 sont reliés par leur émetteur et un point commun à ces émetteurs est relié au collecteur du transistor Q1, dont l'émetteur est relié par la résistance R6 à la tension négative -V ; la base du transistor Q1 est reliée à l'entrée E 71 du multiplieur.

La base du transistor Q2 est reliée à une entrée E 72a du multiplieur et la base du transistor Q3 est reliée à une entrée E 72b ; les entrées E 72a et E 72b constituent l'entrée E72 de la figure 1, cette entrée étant bifilaire. Le collecteur du transistor Q2 est relié au collecteur du transistor Q5, et le collecteur du transistor Q3 est relié au collecteur du transistor Q6. Les transistors Q4 et Q5 sont reliés par leur base et un point commun à ces bases est relié au collecteur du transistor Q5. Les émetteurs des transistors Q4 et Q5 sont reliés à une tension positive + V. Les transistors Q6 et Q7 sont reliés par leur base et un point commun à ces bases est relié au collecteur du transistor Q6. Les émetteurs des transistors Q6 et Q7 sont reliés à la tension positive + V. Le collecteur du transistor Q4 est relié à une sortie S7a du multiplieur et le collecteur du transistor Q7 est reliée à une sortie S76 du multiplieur ; ces deux sorties S7a et S7b constituent la sortie S7 de la figure 1, qui est bifilaire. Les tensions positive + V et négative -V sont celles d'une alimentation continue.

Le filtre de boucle 3, de type connu, comprend un amplificateur opérationnel A0, quatre résistances R1 à R4 et deux condensateurs C1 et C2. L'amplificateur opérationnel a une sortie reliée à la sortie S3 du filtre de boucle, une entrée négative reliée d'une part à la sortie par un circuit série constitué par la résistance R2 et le condensateur C1 et d'autre part à une borne d'entrée E 31a par une résistance R1, et une entrée positive reliée d'une part à une autre borne d'entrée E 31b par la résistance R3 et d'autre part à la masse par un circuit série constitué par la résistance R4 et le condensateur C2. Les entrées E 31a et E 31b constituent l'entrée E 31 de la figure 1, qui est bifilaire.

Un point commun à la résistance R2 et au condensateur C1 est relié à une entrée E 32a elle même reliée à la sortie S7a du multiplieur ; un point commun à la résistance R4 et au condensateur C2 est relié à une autre entrée E 32b elle même reliée à la sortie S7b du multiplieur ; les entrées E 32a et E 32b du filtre de boucle 3 constituent l'entrée E 32 de la figure 1, qui est bifilaire. Les résistances R1 et R3 ont même valeur, les résistances R2 et R4 ont même valeur, et les condensateurs C1 et C2 ont même valeur, C1 = C2 = C.

Dans la phase d'accrochage la tension à l'entrée E6 du filtre passe-haut 6 est un signal carré d'amplitude A ; après passage dans le filtre passe-haut constitué par le condensateur C3 et la résistance R5 on retrouve en sortie S6 du filtre passe-haut le même signal centré sur la tension négative -V de l'alimentation ; ce signal est appliqué au transistor Q1 qui forme avec la résistance R6 une source de courant commandée. Lorsque le signal à la sortie S6 est au niveau haut le courant de collecteur du transistor Q1 a une valeur I fonction de la résistance R6, et lorsque le signal à la sortie de S6 est au niveau bas le transistor Q1 est bloqué, et le courant est nul. Les transistors Q2 et Q3 constituant une paire de différentielle commandée par la tension issue du générateur 8 de signaux carrés basse fréquence ; cette tension étant alternativement positive et négative, comme représenté figure 2, en S8, le courant du transistor Q1 est aiguillé alternativement vers le collecteur du transistor Q2 ou le collecteur du transistor Q3 ; en différentiel on a donc, en sortie S7 du multiplieur 7, le signal représenté figure 2, d'amplitudes I et - I. Les transistors Q4 et Q5 d'une part et Q6 et Q7 d'autre part, constituent deux miroirs de courant de manière à attaquer le filtre de boucle 3 sans saturer les transistors Q2 et Q3.

Le filtre de boucle 3, du type intégral, se comporte vis à vis du courant en intégrateur ; la tension V (S3) en sortie du filtre de boucle est :

$$V\ (S3)\ =\ \tfrac{1}{C}\ \textstyle\int i\ (t)\ dt$$

i (t) étant le courant différentiel, et C = C1 = C2.

Le rôle du filtre passe-haut 6 est donné ci-après.

Lorsque l'accrochage est atteint, la sortie du comparateur à hystérésis peut, suivant le signe de l'écart de fréquence f1 - f2 initial, se trouver à l'état haut. Dans ce cas le transistor Q1 reste passant et continue à alimenter le filtre de boucle, ce qui pertube le fonctionnement. La présence du filtre passe-haut 6 amène, avec une certaine constante de temps, la base du transistor Q1 au potentiel négatif -V, ce qui le bloque. La constante de temps doit être choisie de manière à passer la fréquence de capture de la boucle, cette fréquence de capture étant la fréquence minimale apparaissant en sortie du comparateur à hystérésis 5, mais aussi de manière à bloquer le transistor Q1 et donc à arrêter la dent de scie du signal de balayage avant que celle-ci ne sorte de la plage de capture.

L'intérêt du comparateur à hystérésis est le suivant. En fonctionnement normal le signal E à l'entrée de la boucle à verrouillage de phase reçoit un signal numérique aléatoire possédant une certaine gigue. Les partie hautes fréquences de la gigue vont être démodulées par la boucle et se transmettre sur le signal d'erreur, qui est le signal en sortie S2 du filtre passe-bas 2. Si le comparateur 5 était un comparateur simple, il déclencherait et provoquerait donc le décrochage ; par contre le comparateur à hystérésis ne déclenchera que si l'amplitude de gigue dépasse A-$\epsilon$ , valeur prédéterminée de l'hystérésis. La gigue maximale, G max, admissible en hautes fréquences est :

$$G\ max\ =\ \frac{(A\ -\ \epsilon)}{g1}\ \simeq\ T1\ =\ 0,5\ T1$$

g1 étant le gain du comparateur de phase et égal à A/$\pi$ pour un OU exclusif et T1 la période du signal d'entrée de fréquence f1.

De même, la nature aléatoire du signal d'entrée E, et plus particulièrement les longues suites de "0" et "1" se traduisent en sortie du comparateur de phase 1 par un décrochage ; là encore, l'hystérésis permet de résoudre le problème et d'éviter le décrochage.

Avec un signal d'entrée E à 100 MHz et une boucle à verrouillage de phase constituée par : un comparateur de phase OU exclusif du type F 100 107 de gain g1 = 0,5 V/radian, un filtre passe bas de type RC de fréquence de coupure 30 MHz, un filtre de boucle de constantes de temps R1 C = 4,5 ms et R2 C = 0,224 ms, et un oscillateur commandé en tension de gain g3 = 7MHz/V, on obtient les résultats suivants :

- la boucle seule présente une bande de bruit de 100 KHz et une amplitude maximale de gigue G max = 1,01 ; elle est donc adaptée à une récupération de rythme ;
- la bande de capture est de 280 kHz, le temps d'accrochage maximum correspondant à un saut de fréquence de 6MHz étant de 300 ms ; des sauts plus grands conduisent au décrochage.

On ajoute à la boucle à verrouillage de phase ci-dessus, le dispositif de l'invention constitué par : un comparateur à hystérésis constitué d'un comparateur rapide bouclé, la valeur d'hystérésis étant fixée à 700m V, un filtre passe-haut de fréquence de coupure 36 MHz, un multiplieur deux quadrants, de gain égal à 2,7 m A/V², et un générateur basse fréquence de période T = 15 ms.

Les condensateurs C1 et C2 du filtre de boucle ont une valeur de 1 microfarad ; en conséquence, le signal de balayage a une amplitude crête à crête de 4 volts et une période de 15 ms ; la plage de fréquence balayée par l'oscillateur est donc de 4g3 = 28 MHz.

On obtient, avec le dispositif, les résultats suivants :

- la boucle s'accroche sur des sauts de fréquence de 20 MHz en moins de 23 ms ;
- la gigue maximal G max admissible est de 0,35 T1 (T1 étant la période du signal d'entrée), ce qui est comparable aux chiffres obtenus avec d'autres systèmes ;
- le nombre maximum de "0" consécutifs admissibles dans le signal d'entrée est de 450 sur une séquence pseudo-aléatoire de longueur $2^{15}$ - 1, ce qui est excellent.

Ces résultats montrent que le dispositif d'aide à l'acquisition de l'invention associé à une boucle à verrouillage de phase permet une récupération de rythme bien meilleure que celle obtenue par la boucle à verrouillage seule ; un gain d'au moins vingt est possible sur le temps d'accrochage par rapport à une boucle seule.

## Revendications

1. Procédé d'aide à l'acquisition d'une boucle à verrouillage de phase (BVP) recevant un signal d'entrée (E) de fréquence f1 et comprenant un comparateur de phase (1), un filtre passe-bas (2), un filtre de boucle (3) et un oscillateur commandé en tension (4) et délivrant un signal de fréquence f2 avant accrochage, ledit filtre passe-bas (2) délivrant au filtre de boucle (3) un signal en dents de scie (S2) de fréquence f1-f2, caractérisé par le fait que l'on met en forme, en dehors de la boucle à verrouillage de phase, ledit signal en dents de scie (S2) par un comparateur à hystérésis (5), que l'on filtre le signal mis en forme pour élimination des fréquences inférieures à une fréquence de capture de la boucle à verrouillage de phase, que l'on effectue une multiplication du signal ainsi filtré par un signal carré (S8) basse fréquence pour obtenir un signal multiplié (S7), que l'on intègre ledit signal multiplé pour obtenir un signal de balayage tant que l'acquisition n'est pas obtenue, et que l'on commande ledit oscillateur (4) par ledit signal de balayage pour en faire varier la fréquence, ledit signal de balayage ayant une fréquence égale à celle dudit signal basse fréquence et passant linéairement d'une valeur crête positive à une valeur crête négative et inversement.

2. Procédé selon la revendication 1, caractérisé par le fait que l'intégration du signal multiplié (S7) est effectuée par le filtre de boucle (3).

3. Dispositif d'aide à l'acquisition d'une boucle à verrouillage de phase (BVP), mettant en oeuvre le procédé selon la revendication 2, caractérisé par le fait qu'il comporte un comparateur à hystérésis (5), un filtre passe-haut (6), un multiplieur (7), et un générateur (8) de signaux carrés basse fréquence, le comparateur à hystérésis (5) étant relié en sortie du filtre passe-bas (2) de la boucle à verrouillage de phase, le filtre passe-haut (6) étant relié en sortie du comparateur à hystérésis, le multiplieur (7) ayant une entrée reliée en sortie du filtre passe-haut, une entrée reliée en sortie du générateur (8) et une sortie reliée au filtre de boucle (3) de ladite boucle à verrouillage de phase.

4. Dispositif d'aide l'acquisition selon la revendication 3, caractérisé par le fait que le filtre passe-haut (6) est constitué par un condensateur (C3) connecté entre une entrée (E6) et une sortie (S6) dudit filtre passe-haut et une résistance (R5) connecté entre ladite sortie (S6) et une tension négative (-V), et que le multiplieur (7) comprend un premier miroir de courant (Q4, Q5) un deuxième miroir de courant (Q6, Q7) reliés chacun à une tension positive (+V), un circuit différentiel constitué par deux transistors (Q2, Q3) ayant chacun une base reliée en sortie du générateur, chaque transistor étant relié à un miroir de courant, ledit circuit différentiel étant également relié par un troisième transistor (Q1) et une résistance (R6) en série à ladite tension négative (-V), ledit troisième transistor (Q1) ayant une base reliée à ladite sortie (S6) du filtre passe-haut (6), et chaque miroir de courant étant relié au filtre de boucle (3) de la boucle à verrouillage de phase.

## Claims

1. A method of assisting a phase-locked loop (BVP) in obtaining acquisition, the phase-locked loop receiving an input signal (E) of frequency f1 and including a phase comparator (1), a lowpass filter (2), a loop filter (3), and a voltage-controlled oscillator (4) delivering a signal at frequency f2 prior to locking, said lowpass filter (2) delivering a sawtooth signal (S2) at frequency f1-f2 to the loop filter (3), characterized in that, outside the phase-locked loop, said sawtooth signal (S2) is shaped by a hysteresis comparator (5), that the shaped signal is filtered to remove frequencies below a capture frequency of the phase-locked loop, that the filtered signal is multiplied by a low frequency squarewave signal (S8) in order to obtain a multiplied signal (S7), that said multiplied signal is integrated in order to obtain a sweep signal so long as acquisition has not been obtained, and that said oscillator (4) is controlled by said sweep signal in order to vary its frequency, said sweep signal having a frequency equal to the frequency of said low frequency signal and passing linearly from a positive peak value to a negative peak value, and vice versa.

2. A method according to claim 1, characterized in that the multiplied signal (S7) is integrated by the loop filter (3).

3. An apparatus for assisting a phase-locked loop (BVP) in obtaining acquisition, the apparatus implementing the method according to claim 2 and being characterized in that it comprises a hysteresis comparator (5), a highpass filter (6), a multiplier (7), and a low frequency squarewave generator (8), the hysteresis comparator (5) being connected to the output of the lowpass filter (2) of the phase-locked loop, the highpass filter (6) being connected to the output from the hysteresis comparator, the multiplier (7) having one input connected to the output from the highpass filter, another input connected to the output from the generator (8), and an output connected to the loop filter (3) of said phase-locked loop.

4. An apparatus for providing assistance in obtaining acquisition according to claim 3, characterized in that the highpass filter (6) is constituted by a capacitor (C3) connected between an input (E6) and an output (S6) of said highpass filter, and a resistor (R5) connected between said output (S6) and a negative voltage (-V), and that the multiplier (7) comprises a first current mirror (Q4, Q5), and a second current mirror (Q6, Q7) each connected to a positive voltage (+V), a differential circuit constituted by two transistors (Q2, Q3) each having a base connected to the output of said generator and each connected to one of the current mirrors, said differential circuit being also connected with a third transistor (Q1) and a resistor (R6) in series to said negative voltage (-V), said third transistor (Q1) having a base connected to said output (S6) from the highpass filter (6), and each current mirror being connected to the loop filter (3) of the phase-locked loop.

## Ansprüche

1. Verfahren zur Erleichterung des Einrastens einer Phasenregelschleife (BVP), die ein Eingangssignal (E) mit der Frequenz f1 empfängt und einen Phasenkomparator (1), ein Tiefpaßfilter (2), ein Schleifenfilter (3) und einen spannungsgesteuerten Oszillator (4) aufweist und vor dem Einrasten ein Signal der Frequenz f2 liefert, wobei das Tiefpaßfilter dem Schleifenfilter (3) ein Sägezahnsignal (S2) mit der Frequenz f1-f2 liefert, dadurch gekennzeichnet, daß das Sägezahnsignal (S2) außerhalb der Phasenregelschleife durch einen Hysteresekomparator (5) in Form gebracht wird, daß das geformte Signal zur Beseitigung von Frequenzen unterhalb einer Fangfrequenz der Phasenregelschleife gefiltert wird, daß eine Vervielfachung des so gefilterten Signals durch ein niederfrequentes Rechtecksignal (S8) zur Gewinnung eines vervielfachten Signals (S7) erfolgt, daß das vervielfachte Signal zur Gewinnung eines Wobbelsignals integriert wird, solange die Synchronisation nicht erzielt ist, und daß der Oszillator (4) zum Verändern der Frequenz mit dem Wobbelsignal angesteuert wird, wobei das Wobbelsignal eine Frequenz besitzt, die derjenigen des niederfrequenten Signals gleicht und linear von einem positiven Höchstwert zu einem negativen Höchstwert übergeht, und umgekehrt.

2. Verfahren nach Anspruch 1, dadurch gekennzeichnet, daß die Integration des vervielfachten Signals (S7) durch das Schleifenfilter (3) erfolgt.

3. Einrichtung zur Erleichterung des Einrastens einer Phasenregelschleife (BVP), zur Durchführung des Verfahrens nach Anspruch 2, dadurch gekennzeichnet, daß sie einen Hysteresekomparator (5), ein Hochpaßfilter (6), einen Vervielfacher (7) und einen Generator (8) zur Erzeugung von niederfrequenten Rechtecksignalen aufweist, wobei der Hysteresekomparator (5) an den Ausgang des Tiefpaßfilters (2) der Phasenregelschleife angeschlossen ist, während das Hochpaßfilter (6) mit dem Ausgang des Hysteresekomparators verbunden ist und der Vervielfacher (7) einen mit dem Ausgang des Hochpaßfilters verbundenen Eingang, einen an den Ausgang des Generators (8) angeschlossenen Eingang und einen mit dem Schleifenfilter (3) der Phasenregelschleife verbundenen Ausgang besitzt.

4. Einrichtung zur Erleichterung des Einrastens nach Anspruch 3, dadurch gekennzeichnet, daß das Hochpaßfilter (6) aus einem Kondensator (C3), der zwischen einem Eingang (E6) und einem Ausgang (S6) des Hochpaßfilters geschaltet ist, und einem Widerstand (R5) besteht, der zwischen den genannten Ausgang (S6) und eine negative Spannung (-V) geschaltet ist, und daß der Vervielfacher (7) aus einer ersten Stromspiegelungsschaltung (Q4, Q5), einer zweiten Stromspiegelungsschaltung (Q6, Q7), die beide an eine positive Spannung (+V) angeschlossen sind, und einer Differenzschaltung mit zwei Transistoren (Q2, Q3) besteht, deren jeweilige Basis an den Ausgang des Generators angeschlossen ist, wobei jeder Transistor mit einer Stromspiegelschaltung verbunden und die Differenzschaltung weiter über einen dritten Transistor (Q1) und einen Reihenwiderstand (R6) an die negative Spannung (-V) angeschlossen ist, wobei der dritte Transistor (Q1) mit der Basis an den Ausgang (S6) des Hochpaßfilters (6) angeschlossen und jede Stromspiegelschaltung mit dem Schleifenfilter (3) der Phasenregelschleife verbunden ist.

FIG.1

# F I G . 2

# FIG.3